# EUROPEAN PATENT SPECIFICATION

(11) **EP 3 331 225 B1**
(45) Date of publication and mention of the grant of the patent: **02.09.2020**
(21) Application number: 17204708.6
(22) Date of filing: 30.11.2017
(51) Int. Cl.: H04M 1/18, D03D 1/00, D03D 7/00, A45C 13/00, D03D 15/02, H04M 1/02, H04M 1/23

(54) **ELECTRONIC DEVICE SHELL AND ELECTRONIC DEVICE HAVING THE SAME**
ELEKTRONISCHE VORRICHTUNGSHÜLLE UND ELEKTRONISCHE VORRICHTUNG DAMIT
COQUE DE DISPOSITIF ÉLECTRONIQUE ET DISPOSITIF ÉLECTRONIQUE LA COMPORTANT

(30) Priority: 01.12.2016 CN 201611090975
(43) Date of publication of application: 06.06.2018
(73) Proprietor: Beijing Xiaomi Mobile Software Co., Ltd., Beijing 100085 (CN)
(72) Inventor: CAI, Yangyang, Qinghe Middle Street, Haidian District Beijing, 100085 (CN)
(74) Representative: Hughes, Andrea Michelle

(56) References cited:
- US-A1- 2011 228 458
- US-A1- 2013 016 050
- US-A1- 2014 092 537
- US-A1- 2015 065 206
- US-A1- 2016 157 573
- US-A1- 2016 211 877

## Description

### CROSS REFERENCE TO RELATED APPLICATION

This application claims priority to Chinese Patent Application No. 201611090975.3 filed on December 1, 2016.

### TECHNICAL FIELD

The disclosure relates to the field of electronic technology, and more particularly to an electronic device shell and an electronic device having the same.

### BACKGROUND

A plurality of mature products and/or materials are available for use as a one-piece moulded shell or an outer housing of an electronic device. A shell or housing or cover of an electronic device may be easily scratched, worn, dented or otherwise deformed when the electronic device is subjected to bumps and wear during use, which will affect the cosmetic appearance of the shell and the electronic device significantly. At the same time, a one-piece moulded shell cannot accommodate a local bulge of a main board or non-uniform components, resulting in wasted interior space of the electronic device because the one-piece shell needs to be oversized to accommodate all the components. In addition, for a one-piece moulded shell to accommodate keys and buttons on the electronic device, slots or openings need to be formed in a surface of a shell. The process of forming slots or openings increases the complexity of the process and is more costly. Cases for electronic devices are described in US 2016/211877, US 2014/092537, US 2013/016050 and US 2015/065206.

### SUMMARY

This disclosure provides a shell of an electronic device having excellent flexibility and may reduce damage and dents or wear caused during use.

A shell of an electronic device is provided according to claim 1.

Further, the connecting part may have an adhesive surface, and the woven member is bonded to the adhesive surface of the connecting part. The woven member matches the shape of the electronic device and connects by means of the connecting part. The woven member may be directly bonded to the connecting part, which facilitates installation due to a simplified assembly process.

Further, the connecting part may be provided with at least one catch. The mounting part is provided with at least one slot for accommodating the at least one catch. The connecting part is snap-fit attached to the electronic device by means of the at least one catch. Therefore, it is easy to mount the shell.

Further, the support may be provided with at least one arc-shaped transition surface configured to match at least one corner of the electronic device. The at least one arc-shaped transition surface (i.e., rounded corners) makes the electronic device more aesthetically pleasing and ergonomic to hold.

Further, the connecting part may be configured as a rigid support provided around a perimeter of the woven member. The mounting part includes a crimping groove configured to engage the rigid support of the connecting part in a locking manner. The edge of the woven member is directly fixed to the electronic device by means of the crimping groove so that the connecting structure of the shell and the electronic device becomes simple and reliable.

Further, the electronic device may include a camera. The woven member is provided with an opening configured to match the shape of the camera so that the camera may be used through the opening.

Further, the edge of the opening may be provided with a locking member, and the locking member is configured to lock the edge of the opening. The locking member locks the edge of the opening to prevent the woven member from being torn or covering the camera.

Further, the locking member may be provided with an annular groove. The edge of the opening is accommodated in the annular groove. With the edge of the opening accommodated and locked by the annular groove provided on the locking member, the structure is simple and reliable, and the locking member may shield the edge of the opening so that the shell is attractive.

Further, the woven member may be formed by a plurality of interwoven metal wires. Therefore, the woven member of metal wires is configured for improved flexibility and resilience, which results in improved wear resistance. Further still, the woven member may be formed by a plurality of interwoven non-metallic wires. Therefore, the woven member may have similar properties to the metal wires and potentially be lighter and more cost effective.

The technical solution provided according to an example of the disclosure may include the following beneficial effects: the elastic woven shell is capable of effectively avoiding damage and dents in the shell caused by a bumps, impacts, or wear, improved adaptation to the variations of the structural design of the electronic device, and reductions in the manufacturing difficulty of the product and lower production costs.

It is to be understood that both the foregoing general description and the following detailed description are merely exemplary and illustrative and do not limit the disclosure.

### BRIEF DESCRIPTION OF DRAWINGS

The drawings herein are incorporated in and constitute a part of the specification to depict embodiments coinciding with the disclosure and serve to explain the principles of the disclosure together with the specification.
FIG.1 illustrates an exploded view of a shell of an electronic device and an electronic device according to an example of the disclosure.
FIG. 2 illustrates an exploded view of a structure of a mobile phone shell according to an example of the disclosure.
FIG. 3A illustrates elevational views of a woven member of a mobile phone shell when under stress in a first direction according to an example of the disclosure.
FIG. 3B illustrates elevational views of a woven member of a mobile phone shell when under stress in a second direction according to an example of the disclosure.
FIG. 4 illustrates a perspective view of a rear surface of a mobile phone according to an example of the disclosure.

### DETAILED DESCRIPTION

An exemplary embodiment will be described in detail herein, examples of which are shown in the accompanying drawings. When the following description refers to the accompanying drawings, the same numerals in different drawings denote the same or similar elements unless otherwise indicated. The examples described in the following exemplary embodiment are not representative of all examples coinciding with the present disclosure. In contrast, they are merely examples of devices and methods coinciding with some aspects of the present disclosure as detailed in the appended claims.

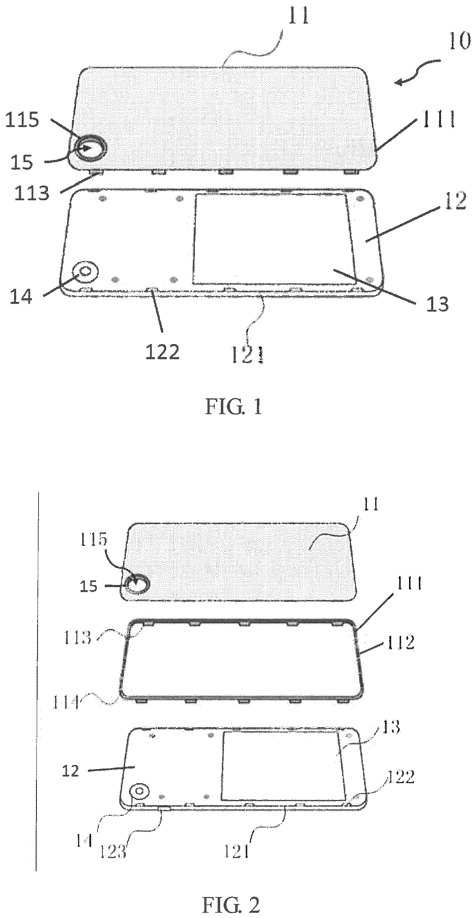

FIG.1 illustrates an exploded view of a shell of an electronic device and an electronic device according to an example of the disclosure. The shell of an electronic device may also be referred to as an electronic device shell. Hereinafter, a technical solution of the disclosure will be described in detail with reference to an example in which a mobile phone is used as an electronic device and a mobile phone shell is used as a shell of an electronic device. As shown in FIG. 1, a shell 10 of an electronic device includes a main body 11 and a support or connecting part 111 provided on the main body 11; the electronic device 12 has a mounting part 121 that matches the shape of and is configured to form a fixed connection to the connecting part 111. The main body 11 includes a woven member. According to the present invention, the main body 11 is a woven member. The mounting part 121 may be disposed on an edge of the electronic device.

Since the woven member 11 has a particular degree of flexibility, use of the woven member as the shell 10 of the electronic device 12 may reduce cosmetic appearance problems of the electronic device 12 caused by wear and use.

FIG. 2 illustrates an exploded diagram of a structure of a mobile phone shell used as an example of a shell of an electronic device according to an example of the disclosure. As shown in FIG. 2, the electronic device 12 is depicted as a mobile phone. The connecting part 111 is a rigid support having an adhesive surface 112, and the woven member 11 may be bonded to the adhesive surface 112. The woven member 11 may be directly bonded to the support and matches the mobile phone 12 through the connecting part 111. Therefore, the mobile phone shell is easy to assemble and the manufacturing process is simple.

As shown in FIG. 2, the connecting part 111 is configured as a frame-shaped support which may not only serve as a connecting member between the woven member 11 and the mobile phone 12 but also support the woven member 11. A plurality of catches 113 are provided around the connecting part 111. Correspondingly, a mounting part 121 of the mobile phone 12 is provided with a plurality of slots 122 for accommodating the plurality of catches 113. The connecting part 111 may be snap-fit attached to the mobile phone 12 by the plurality of catches 113. Therefore, it is easy to operate during use. At the same time, the plurality of catches 113 and the plurality of slots 122 are provided around the connecting part 111 and the mobile phone 12, respectively, to enhance the fixed connection between the mobile phone shell and the mobile phone.

As shown in FIG. 2, the connecting part 111 is provided with at least one arc-shaped transition surface 114 which matches the rounded shape (i.e., corners) of the mobile phone 12 at the corners of the device. The arc-shaped transition surface 114 makes the mobile phone 12 more attractive and ergonomic to grip as a whole. It is contemplated that the electronic device 12 and the shell 10 may be any shape besides the rectangle with rounded corners depicted in the present figures.

In one embodiment, the connecting part 111 forms a rigid support provided around a perimeter of the woven member 11; and the mounting part 121 has a crimping groove which is configured to engage with the rigid support in a locking manner. The edge of the woven member 11 is directly fixed to the electronic device 12 by means of the crimping groove so that the connecting structure of the shell 10 and the electronic device 12 is simple and reliable.

The woven member 11 may also be connected to the mobile phone 12 in other manners such as bonding or welding.

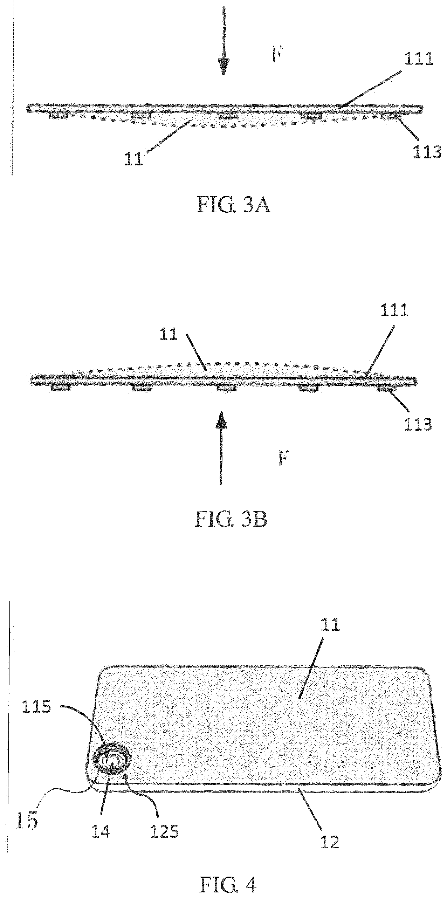

FIGs. 3A and 3B illustrate deformation of a woven member under a stress according to an example of the disclosure. As depicted in FIG. 3A, the woven member 11 is configured to flex inwards towards the electronic device 12 when a force F is applied. As depicted in FIG. 3B, the woven member 11 is configured to flex outwards away from the electronic device 12 when a force F is applied. As shown in FIG. 2, the mobile phone 12 is provided with a raised side key 123. Since the woven member 11 has a particular degree of flexibility (as shown by FIGS. 3A and 3B), the woven member 11 may be abutted on or enclosing the side key 123 in a flexible manner when covering the side key 123. There is no need to mount the side key 123 by slotting the mobile phone shell 10 which causes the production process of the mobile phone shell 10 to be simpler, effectively reducing the production cost and the assembling difficulty. At the same time, a corresponding sign or marking may be provided on an outer side of the corresponding portion of the woven member 11 covering the side key 123 so as to facilitate use by indicating the location of the side key 123 under the woven member 11.

As shown in FIG. 2, a main board of the mobile phone 12 has a bulge 13. The woven member 11 is partially and flexibly abutted on the bulge 13 of the main board of the mobile phone when covering the body of the mobile phone 12. Due to the flexibility of the woven member 11, the portion of the woven member 11 covering the bulge 13 may be properly stretched without having to make a design to increase the interior space of the mobile phone for the bulge 13. Therefore, the product has a high adaptability.

FIG. 4 illustrates a structure schematic diagram of a rear surface of the mobile phone 12. As shown in FIGs. 1, 2, and 4, the woven member 11 is provided with an opening 115 which is configured to match the shape of the camera 14 of the mobile phone 12. The opening 115 in the woven member 11 is used to facilitate the use of the camera 14. The edge of the opening 115 is provided with a locking member 15. The locking member 15 is configured to lock the edge of the opening 115 to prevent the woven member 11 from being torn.

The locking member 15 is provided with an annular groove 125, and the edge of the opening 115 is accommodated and locked in the annular groove 125. With the edge of the opening 115 accommodated and locked by the annular groove 125 provided on the locking member 15, the structure is simple and reliable. At the same time, the locking member 15 also shields the edge of the opening 115 to enhance the overall aesthetic appearance of the mobile phone shell.

In one embodiment, the edge of the opening 115 may also be locked directly using an edge-locking method of the weaving technique.

In one embodiment, the woven member 11 may be formed by interweaving a plurality of metal wires. The woven member 11 made of metal wires provides better flexibility, resilience, and has higher resistance to wear.

In another embodiment, the woven member 11 may also be formed by interweaving tough non-metallic wires. The material of the non-metallic wires may be elastic fibre, plastic, resin, etc.

In addition, an uneven surface formed on the woven member 11 in the weaving process may increase the frictional force of the mobile phone shell and play a slip-proof role during use.

Other implementations of the present disclosure will readily occur to those skilled in the art after consideration of the specification and practice of the present disclosure disclosed herein. The present disclosure is intended to cover any variations, uses, or adaptive changes of the present disclosure that follow the general principle of the present disclosure and include the common general knowledge or conventional technical means in the art undisclosed in the present disclosure. The specification and examples are to be merely regarded as exemplary, and the true scope of the invention are indicated by the following claims.

It is to be understood that the disclosure is not limited to the specific structures described above and shown in the accompanying drawings, and that different modifications and changes may be made without departing from the scope thereof. The scope of the disclosure is limited only by the appended claims.

## Claims

1. A shell of an electronic device, wherein the shell comprises:
a main body defining a perimeter; and
a connecting part (111) that is provided around and connected with the perimeter of the main body,
wherein the main body consists of a woven member (11) supported by the connecting part (111) and is provided with an opening (115) configured to match a shape of a camera of the electronic device, the connecting part (111) is a frame-shaped support and the electronic device includes a mounting part (121) that is configured to form a fixed connection to the connecting part in a way that the main body covers a rear side of the electronic device.

2. The shell according to claim 1, wherein the connecting part includes an adhesive surface (112), and the woven member is bonded to the adhesive surface of the connecting part.

3. The shell according to claim 2, wherein the connecting part is provided with at least one catch (113), and the mounting part (121) is provided with at least one slot (122) for accommodating the at least one catch.

4. The shell according to claim 3, wherein the connecting part is provided with at least one arc-shaped transition surface (114) configured to match at least one corner of the electronic device.

5. The shell according to any preceding claim, wherein the connecting part is configured as a rigid support provided around the perimeter of the woven member, and the mounting part includes a crimping groove configured to engage the rigid support of the connecting part in a locking manner.

6. The shell according to any preceding claim, wherein an edge of the opening is provided with a locking member (15), and the locking member is configured to lock the edge of the opening.

7. The shell according to claim 6, wherein the locking member is provided with an annular groove (125), and the edge of the opening is accommodated in the annular groove.

8. The shell according to any preceding claim, wherein the woven member comprises a plurality of interwoven metal wires or a plurality of interwoven non-metallic wires.

9. An electronic device comprising: a mounting part (121); a shell (10) as claimed in any preceding claim.

## Patentansprüche

1. Hülle einer elektronischen Vorrichtung, wobei die Hülle umfasst:
einen Hauptkörper, der einen Außenumfang definiert; und
ein Verbindungsteil (111), das um den Außenumfang des Hauptkörpers bereitgestellt und damit verbunden ist,
wobei der Hauptkörper aus einem gewobenen Bauteil (11) besteht, das von dem Verbindungsteil (111) gestützt wird und mit einer Öffnung (115) bereitgestellt ist, die konfiguriert ist, einer Form einer Kamera der elektronischen Vorrichtung zu entsprechen, wobei das Verbindungsteil (111) eine rahmenförmige Stütze ist und die elektronische Vorrichtung ein Montageteil (121) beinhaltet, das konfiguriert ist, eine starre Verbindung mit dem Verbindungsteil auf eine Weise zu bilden, dass der Hauptkörper eine Rückseite der elektronischen Vorrichtung abdeckt.

2. Hülle nach Anspruch 1, wobei das Verbindungsteil eine Klebeoberfläche (112) beinhaltet und das gewobene Element an die Klebeoberfläche des Verbindungsteils gebondet ist.

3. Hülle nach Anspruch 2, wobei das Verbindungsteil mit mindestens einer Raste (113) bereitgestellt ist und das Montageteil (121) mit mindestens einem Schlitz (122) bereitgestellt ist, um die mindestens eine Raste aufzunehmen.

4. Hülle nach Anspruch 3, wobei das Verbindungsteil mit mindestens einer bogenförmigen Übergangsoberfläche (114) bereitgestellt ist, die konfiguriert ist, mindestens einer Ecke der elektronischen Vorrichtung zu entsprechen.

5. Hülle nach einem vorstehenden Anspruch, wobei das Verbindungsteil als eine starre Stütze konfiguriert ist, die um den Außenumfang des gewobenen Bauteils bereitgestellt ist, und das Montageteil eine Klemmkerbe beinhaltet, die konfiguriert ist, mit der starren Stütze des Verbindungsteils auf eine verriegelnde Weise einzugreifen.

6. Hülle nach einem vorstehenden Anspruch, wobei eine Kante der Öffnung mit einem Verriegelungsbauteil (15) bereitgestellt ist und das Verriegelungsbauteil konfiguriert ist, die Kante der Öffnung zu verriegeln.

7. Hülle nach Anspruch 6, wobei das Verriegelungsbauteil mit einer ringförmigen Kerbe (125) bereitgestellt ist und die Kante der Öffnung in der ringförmigen Kerbe aufgenommen ist.

8. Hülle nach einem vorstehenden Anspruch, wobei das gewobene Bauteil eine Vielzahl von verflochtenen Metalldrähten oder eine Vielzahl von verflochtenen nichtmetallischen Drähten umfasst.

9. Elektronische Vorrichtung umfassend:
ein Montageteil (121);
eine Hülle (10) nach einem vorstehenden Anspruch.

## Revendications

1. Coque d'un dispositif électronique, dans laquelle la coque comprend :
un corps principal définissant un périmètre ; et
une pièce de connexion (111) qui est prévue autour et reliée au périmètre du corps principal,
dans laquelle le corps principal est constitué d'un élément tissé (11) supporté par la partie de connexion (111) et est pourvu d'une ouverture (115) configurée pour correspondre à une forme d'une caméra du dispositif électronique, la partie de connexion (111) est un support en forme de cadre et le dispositif électronique inclut une partie de montage (121) qui est configurée pour former une connexion fixe à la partie de connexion de manière à ce que le corps principal recouvre un côté arrière du dispositif électronique.

2. Coque selon la revendication 1, dans laquelle la partie de connexion inclut une surface adhésive (112), et l'élément tissé est lié à la surface adhésive de la partie de connexion.

3. Coque selon la revendication 2, dans laquelle la partie de connexion est pourvue d'au moins une languette de retenue (113), et la partie de montage (121) est pourvue d'au moins une fente (122) pour loger la au moins une languette de retenue.

4. Coque selon la revendication 3, dans laquelle la partie de connexion est pourvue d'au moins une surface de transition en forme d'arc (114) configurée pour correspondre à au moins un coin du dispositif électronique.

5. Coque selon l'une quelconque des revendications précédentes, dans laquelle la partie de connexion est configurée sous la forme d'un support rigide prévu autour du périmètre de l'élément tissé, et la partie de montage inclut une rainure de sertissage configurée pour venir en prise avec le support rigide de la partie de connexion de manière verrouillable.

6. Coque selon l'une quelconque des revendications précédentes, dans laquelle un bord de l'ouverture est pourvu d'un élément de verrouillage (15), et l'élément de verrouillage est configuré pour verrouiller le bord de l'ouverture.

7. Coque selon la revendication 6, dans laquelle l'élément de verrouillage est pourvu d'une rainure annulaire (125), et le bord de l'ouverture est reçu dans la rainure annulaire.

8. Coque selon l'une quelconque des revendications précédentes, dans laquelle l'élément tissé comprend une pluralité de fils métalliques entrelacés ou une pluralité de fils non métalliques entrelacés.

9. Dispositif électronique comprenant :
une partie de montage (121) ;
une coque (10) selon l'une quelconque des revendications précédentes.
